# EUROPEAN PATENT APPLICATION

(11) **EP 0 654 347 A1**
(43) Date of publication of application: **24.05.1995**
(21) Application number: 94203190.7
(22) Date of filing: 02.11.1994
(51) Int. Cl.: B32B 31/00, G03F 7/34

(54) **Device for producing an imaging element**

(30) Priority: 19.11.1993 BE 9301277; 03.12.1993 BE 9301336
(71) Applicant: AGFA-GEVAERT naamloze vennootschap, B-2640 Mortsel (BE)
(72) Inventor: Burtin, Jean, c/o Agfa-Gevaert N.V., B-2640 Mortsel (BE); De Niel, Marc, c/o Agfa-Gevaert N.V., B-2640 Mortsel (BE); Van de Poel, Alex, c/o Agfa-Gevaert N.V., B-2640 Mortsel (BE); Van Baden, Lodewijk, c/o Agfa-Gevaert N.V., B-2640 Mortsel (BE); Van Goethem, Luc, c/o Agfa-Gevaert N.V., B-2640 Mortsel (BE); Van den Bergh, Rudolf, c/o Agfa-Gevaert N.V., B-2640 Mortsel (BE)

(57) **Abstract**

Device for producing an imaging element by peeling apart an image-receiving base (3) and an imaging-layer carrying base (2) laminated thereto, provided with a common drum (9), a first roller (6) for the lamination, and a second roller (7) for the delamination.

## Description

### BACKGROUND OF THE INVENTION

### Field of the invention

The present invention relates to a device for producing an image by laminating an image-receiving layer to an imaging layer that has been image-wise exposed by means of laser radiation.

### Description of the prior art

Several proposals have been disclosed so far for obtaining an imaging element suited for development according to dry process steps with the main purpose of avoiding the use of any processing liquid.

In addition to the substantial ecological advantages of dry processing, the image carrier by itself offers the considerable benefit of being suited for daylight processing. However, these features are counterbalanced by the relatively low sensitivity and the high-power exposing equipment involved.

The latent-image formation commonly occurs by introducing selective adhesion differences between the density-producing and the image-carrying layers by means of an image-wise heat treatment. The processing, or visible-image formation, is performed by a sequential laminating-delaminating phase of a sheet against the image-carrying face of the recorded film. The imaging material, as described e.g. in EP 93 201 858, generally comprises a transparent base carrying an imaging layer. The imaging layer is covered with a release layer and a thermosensitive adhesive layer having a second-order transition temperature ranging from 20 to 60 °C.

The processing occurs by laminating a transfer sheet to the thermosensitive adhesive layer under pressure and at increased temperature. Such transfer sheet may be any coated or uncoated paper type, polyester or any other flat base. The visible image is produced by peeling apart again the sandwich of the two above-mentioned sheets, i.e. the image-carrying and the transfer sheets. During the separation or delamination process the image-wise recorded areas of the imaging and release layers are left on the transparent base. The non-image areas, i.e. the layer areas that have not been image-wise recorded, together with the release layer remain adhered to the transfer sheet. As a result of the separation process two complementary images are generated, i.e. one on the transparent base and the other on the transfer sheet.

For several reasons :
1. the highest possible production speed,
2. speed range for allowing lamination and delamination to take place at the same speed,
3. speed range for obtaining the optimum image quality irrespective of the material applied,
it is essential to apply a sufficiently high amount of heat to the sheets within a relatively short period of time. This can be realised by exposing the transfer sheet and/or film either for a short time to a rather high temperature or for a prolonged time to a lower temperature. A sufficient heat supply to the thermosensitive adhesive layer is required for heating it to above its second-order transition temperature so that it softens and exhibits its adhesive behaviour.

For the same reasons the initiation or start of delamination and the actual delamination or separation of the two sheets at the delamination side should occur at the highest possible speed. However, there are following restrictions :
1. at its bottom side speed is restricted by the specified minimum production speed and the speed-dependent image quality
2. at its top side by the possibilities of accelerating from standstill or low speed to that high speed.

Practical values are as follows :
- initiation speeds ranging from 5 to 20 m/min
- delamination speeds varying between 5 and 10 m/min.

### OBJECT OF THE INVENTION

It is an object of the present invention to provide a device for overcoming the above-mentioned restrictions.

### SUMMARY OF THE INVENTION

According to the present invention a device is provided for producing an imaging element by laminating an image-receiving base (3) to a base (2) carrying an imaging layer and subsequently peeling it away therefrom, the device being provided with means for performing said laminating and peeling-apart, wherein said means comprise a drum (4) with a clamp (5) for gripping the edge of one base (2), a first platen roller (6) for laminating the other base (3) to the first base (2) on the drum (4), and a second platen roller (7) for delaminating the second base (3) from the first base (2).

### DETAILED DESCRIPTION OF THE INVENTION

The present invention is described hereinbelow by way of illustration referring to the enclosed diagram.

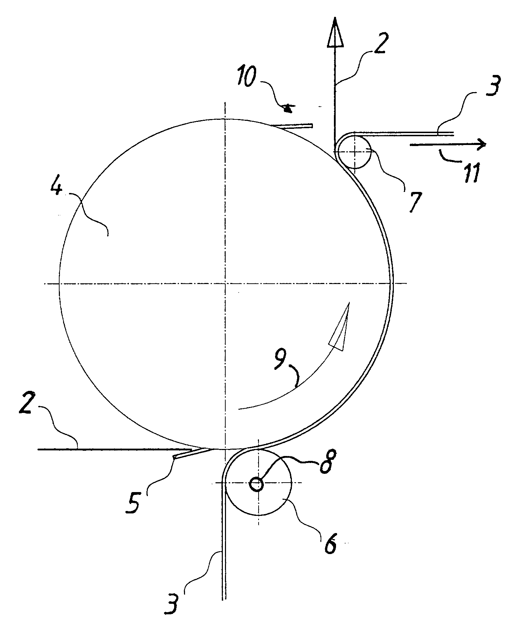

On the diagram a process drum used both for laminating and delaminating is designated by the figure 4. A recorded sheet 2 of the type disclosed in the above-mentioned patent application is fed between the clamp grippers 5 of drum 4. The grippers 5 close and drum 4 revolves in the direction indicated by the arrow 9. A transfer sheet 3 is warmed up by roller 6 heated by a heating element 8, gets in contact with the recorded sheet 2 and by being pressed between the heated roller 6 and the process drum 4 it is laminated to that sheet 2.

The above described lamination zone is followed by a cooling zone over the process drum and thereupon clamp 5 having reached position 10 opens thereby releasing the leading edge of the recorded sheet 2 for further transport. At that instant the transfer sheet 3 is deviated from its course by auxiliary roller 7 and removed further in the direction indicated by the arrow 11, the delamination angle being dependent on the exit angle of the recorded sheet 2 past roller 7 and being defined by the diameter of roller 7 and the guiding direction of the recorded sheet 2.

The present invention is not restricted to the example as described above. An alternative embodiment of the present invention may be equipped as follows. .

The device comprises means for heating at least one of the two bases at a location on the path thereof situated before the place where the lamination is effected. Said means are arranged for the heating of both bases.

These means comprise a curved guide, e.g. a bended fixedly mounted guide plate, for the travelling path of the base(s).

These means comprise infrared radiators mounted somewhat distant from the path traversed by the base(s). Said radiators are arranged for heating a guide roller for the base(s).

These means comprise an internally heated guide roller, e.g. a roller heated by means of circulating heated liquid.

These means comprise an infrared-transparent roller, e.g. a glass drum, with internal infrared radiation.

## Claims

1. Device for producing an imaging element by laminating an image-receiving base (3) to a base (2) carrying an imaging layer and subsequently peeling it away therefrom, the device being provided with means for performing said laminating and peeling-apart, wherein said means comprise a drum (4) with a clamp (5) for gripping the edge of one base (2), a first platen roller (6) for laminating the other base (3) to the first base (2) on the drum (4), and a second platen roller (7) for delaminating the second base (3) from the first base (2).

2. Device according to claim 1, wherein the first platen roller (6) is provided with means (8) for the heating thereof.

3. Device according to claim 1 or 2, wherein means are provided for heating at least one of the two bases at a location on the path thereof situated before the place where the laminating is effected.

4. Device according to claim 3, wherein said means are arranged for the heating of both bases.

5. Device according to claim 3 or 4, wherein said means comprise a curved guide for the travelling path of the base(s).

6. Device according to claim 3 or 4, wherein said means comprise infrared radiators.

7. Device according to claim 6, wherein said infrared radiators are arranged for heating a guide roller for the base(s).

8. Device according to claim 3, wherein said means comprise an internally heated guide roller.

9. Device according to claim 3, wherein said means comprise an infrared-transparent roller with internal infrared radiator.

10. Device according to claim 8, wherein said roller is heated by the circulation of a heated liquid.
